**Europäisches Patentamt**

**European Patent Office**

**Office européen des brevets**

(19)

(11) Veröffentlichungsnummer : **0 400 386 B1**

(12)                    # EUROPÄISCHE PATENTSCHRIFT

(45) Veröffentlichungstag der Patentschrift :
**24.08.94 Patentblatt 94/34**

(51) Int. Cl.$^5$ : **G01R 31/308**

(21) Anmeldenummer : **90109038.1**

(22) Anmeldetag : **14.05.90**

(54) **Verfahren zur Bestimmung der Rekombinationsgeschwindigkeit von Minoritätsträgern an Grenzflächen zwischen Halbleitern und anderen Substanzen.**

(30) Priorität : **31.05.89 DE 3917721**

(43) Veröffentlichungstag der Anmeldung :
**05.12.90 Patentblatt 90/49**

(45) Bekanntmachung des Hinweises auf die Patenterteilung :
**24.08.94 Patentblatt 94/34**

(84) Benannte Vertragsstaaten :
**DE FR GB IT NL**

(56) Entgegenhaltungen :
**EP-A- 0 295 440**
**DE-B- 1 027 321**
**US-A- 4 494 069**

(56) Entgegenhaltungen :
**14:TH IEEE PHOTOVOLTAIC SPECIALISTS CONF.-1980 7. Januar 1980, SAN DIEGO,USA-Seiten 596 - 600; KIM ET AL.: 'A NEW METHOD OF MEASURING DIFFUSION LENGTHAND ...' JOURNAL OF THE ELECTROCHEMICAL SO-CIETY. Bd. 135, Nr. 11, 1988, MANCHESTER, NEWHAMPSHIRE US Seiten 2831 - 2835; LEH-MANN & FOLL:'MINORITY CARRIER DIFFU-SION LENGTH...'**

(73) Patentinhaber : **SIEMENS AKTIENGESELLSCHAFT**
**Wittelsbacherplatz 2**
**D-80333 München (DE)**

(72) Erfinder : **Föll, Helmut, Dr.**
**Wemdinger Strasse 40**
**D-8000 München 80 (DE)**
Erfinder : **Lehmann, Volker, Dr.**
**Neumarkter Strasse 82a**
**D-8000 München 80 (DE)**

**Beschreibung**

Die Erfindung betrifft ein Verfahren nach dem Oberbegriff des Patentanspruchs 1.

Die Grenzflächenrekombinationsgeschwindigkeit S ist ein Maß für die Geschwindigkeit, mit der Minoritätsträger an einer Grenzfläche durch Rekombination verschwinden (siehe S. M. Sze, Physics of Semiconductors, Whiley-Interscience Publ.). Sie ist proportional zur Grenzflächenzustandsdichte N, d.h. der Dichte an elektrisch aktiven Zuständen in der Bandlücke.

Zur Charakterisierung von Grenzflächen, wie z.B. der Grenzfläche Si-SiO$_2$ bezüglich ihrer elektrischen Eigenschaften ist S oder N einer der wichtigen Parameter. Die elektrischen Eigenschaften und das Langzeitverhalten von Transistoren in integrierten Schaltungen werden dadurch beeinflußt. Darüber hinaus kann die Grenzflächenrekombinationsgeschwindigkeit S auch als Kontrollgröße bei der Überwachung von Schichtherstellverfahren bei der Fertigung mikroelektronischer Bauteile verwendet werden.

Für die Bestimmung von S kann die Störstellenspektroskopie (deep level transient spectroscopy, DLTS) angewandt werden; ein solches Verfahren ist in dem Artikel von N. M. Johnson, J. Vac. Sci. Techn. 21 (1982) 303 angegeben. Dazu muß auf den Halbleiter ein MOS-Kondensator aufgebracht werden. An das Metallgate wird eine Wechselspannung angelegt, die einer Gleichspannung aufgesetzt ist, so daß die Grenzflächenzustände in der ersten Halbphase mit Ladungsträgern aufgefüllt werden und diese in der zweiten Halbphase in das Leitungsband des Halbleiters emittiert werden. Wird diese Emissionsrate über einen Temperaturbereich gemessen, läßt sich daraus die Grenzflächenzustandsdichte und die Rekombinationsgeschwindigkeit bestimmen.

Eine zweite Methode zur Bestimmung der Rekombinationsgeschwindigkeit mißt die zeitliche Änderung der Kapazität eines solchen MOS-Kondensators, die ihre Ursache in der thermischen Erzeugung von Elektron-Loch-Paaren hat (siehe K. S. Rabbani et. al., Solid State Electronics 24 (1981) 661).

Die erwähnten Verfahren benötigen spezielle Teststrukturen und erfordern bereits bei Messungen mit geringer Ortsauflösung einen hohen Zeitaufwand.

Aufgabe der vorliegenden Erfindung ist es daher, ein einfaches Verfahren mit hoher Ortsauflösung zur Bestimmung der Rekombinationsgeschwindigkeit von Minoritätsträgern an Grenzflächen zwischen Halbleitern und anderen Substanzen anzugeben, bei dem keine Teststrukturen nötig sind.

Diese Aufgabe wird bei einem Verfahren der eingangs genannten Art durch die kennzeichnenden Merkmale des Patentanspruchs 1 gelöst.

Weiterbildungen der Erfindung sind Gegenstand von Unteransprüchen. Die Erfindung wird nachfolgend anhand von Ausführungsbeispielen näher erläutert, die in den Zeichnungen dargestellt sind.

Fig. 1             zeigt schematisch einen stark vereinfachten Querschnitt durch einen Elektrolyt-Doppelzelle

Fig. 2 - 4        zeigen ortsaufgelöste Messungen über einen Silicium-Wafer

2) des Rückseitenfotostroms ohne Elektrolytbefüllung der vorderen Halbzelle, $I_2'$

3) des Rückseitenfotostroms mit Elektrolytbefüllung der vorderen Halbzelle, $I_2$

4) der Rekombinationsgeschwindikeit S

Gemäß Fig .1 befindet sich ein Halbleiterkristallkörper (sog. Wafer) 3 zwischen zwei mit Elektrolyt 5, 6 befüllbaren Halbzellen 1, 2. Als Elektrolyt kann, z.B. 2 %ige Flußsäure mit Zusatz eines Netzmittels verwendet werden. Ist die 1.Halbzelle 1 mit Elektrolyt gefüllt, so steht dieser in Kontakt mit einer Elektrode 7 und der Vorderseite 9 des Wafers 3. Der Wafer 3 ist über einen ohmschen Kontakt 4 an eine Gleichspannungsquelle 13 angeschlossen, deren anderer Pol über ein Amperemeter 11 mit der Elektrode 7 verbunden ist. Die 2. Halbzelle 2 an der Waferrückseite 10 ist analog aufgebaut: eine Elektrode 8 im Elektrolyt 6 ist über ein Amperemeter 12 mit einer Gleichspannungsquelle 14 verbunden, deren anderer Pol ebenfalls über den ohmschen Kontakt 4 an den Wafer 3 angeschlossen ist. In jeder Halbzelle kann der Elektrolyt umgewälzt und entlüftet werden (nicht dargestellt).

An die Gleichspannungsquelle 14 wird eine Spannung derart angelegt, daß sich auf der Waferrückseite 10 eine sperrende Raumladungszone bildet (z.B. werden bei einem p-Siliciumwafer etwa -5 V an den Kontakt 4 angelegt). Wird nun die Vorderseite 9 mit Licht sichtbarer Wellenlänge der Lichtquelle 15 beleuchtet, werden in einer dünnen Schicht (1 - 2 $\mu$) Elektronen-Loch-Paare erzeugt. Die Minoritätsträger diffundieren zur Scheibenrückseite 10 und rufen in der Halbzelle 2 einen Fotostrom $I_2$ hervor, der mit dem Amperemeter 12 gemessen wird. Der Fotostrom ist bei bekannter Waferdicke von der Diffusionslänge L der Minoritätsträger im Halbleiter 3 und von der Grenzflächenzustandsdichte N an der Wafervorderseite 9 abhängig. Durch die Befüllung der 1. Halbzelle 1 mit einem Elektrolyt 5 ist N so gering, daß nur ein vernachlässigbarer Teil der erzeugten Minoritätsträger an der Vorderseite 9 rekombinieren, so daß $I_2 = I_2$ (L).

Wird die Meßhalbkammer 1 jedoch nicht mit einem Elektrolyten befüllt, können die jetzt an der beliebigen Grenzfläche (z.B. Si-SiO$_2$, falls die Siliciumscheibe oxidiert ist) vorhandenen Grenzflächenzustände den jetzt an der Rückseite 10 gemessenen Fotosstrom $I_2'$ stark beeinflussen; dies ist in dem Artikel vom V. Lehmann und H. Föll in J. Electrochem. Soc. 135 (1988) 2831 näher erläutert. Der in diesem Fall gemessene Strom $I_2'$ ist dann eine Funktion der Diffusionslänge L und der Grenzflächenrekombinationsgeschwindigkeit S, also $I_2'$ = $I_2'$ (L,S).

Um aus nacheinanderfolgenden Messungen von $I_2$ und $I_2'$ die Rekombinationsgeschwindigkeit S ermitteln zu können muß außerdem die Diffusionslänge L bestimmt werden. Dies kann vorteilhaft mit dem in EPA 0295 440 beschriebenen Verfahren erfolgen: bei befüllten Halbzellen 1,2 wird zusätzlich der Vorderseitenfotostrom $I_1$ mit Hilfe des Amperemeters 11 gemessen, indem mittels der Gleichspannungsquelle 13 auf der Vorderseite 9 des Wafers 3 eine sperrende Raumladungszone erzeugt wird und und mit Hilfe der Beleuchtung durch die Lichtquelle 15 ein Fotostrom $I_1$ in der vorderen Halbzelle 1 erzeugt wird (die rückseitige Halbzelle 2 wird nicht beschaltet). Dieser ist praktisch unabhängig von Diffusionslänge L und aufgrund der Befüllung der 1. Halbzelle 1 auch von der Grenzflächenzustandsdichte N. Aus den Stromstärken $I_1$ und $I_2$ kann die Diffusionslänge L berechnet werden.

Ist die Diffusionslänge L z. B. aus anderen Messungen bereits bekannt, ist der Stromkreis der 1. Halbzelle nicht erforderlich: Gleichspannungsquelle 13, Amperemeter 11 und Elektrode 7 können dann entfallen.

Die Grenzflächenrekombinationsgeschwindigkeit S wird nun aus L, $I_2$ und $I_2'$ mit Hilfe der mathematischen Gleichung

$$S = \frac{D\,\alpha\,(1-A)}{A - \alpha\,L\,\tanh(X/L)}$$

wobei

D = Diffusionskonstanten der Ladungsträger,
α = Absorptionskonstante des Lichtes,
A = $I_2/I_2'$ = Verhältnis des 2. Fotostroms zum ersten Fotostrom
L = Diffusionslänge,
X = Dicke der Scheibe,

berechnet. Wird die Scheibe in beiden Meßschritten ganzflächig beleuchtet, erhält man so den Mittelwert von S über die Scheibe. Beim Abrastern der Vorderseite mit einem fokussierten Lichtstrahl oder einem Laserstrahl kann die Rekombinationsgeschwindigkeit S ortsaufgelöst bestimmt werden.

Eine Messung von S kann nun wie folgt durchgeführt werden: in einem ersten Meßschritt wird der Rückseitenfotostrom $I_2'$ gemessen, ohne die Halbkammer 1 mit einem Elektrolyten zu befüllen. Die Vorderseite 9 wird mit dem Licht eines Helium-Neon-Lasers 15 abgerastert. Die Meßwerte werden für jeden Punkt der Scheibe einzeln gespeichert. In einem zweiten Meßschritt wird die 2. Halbzelle jetzt mit 2 %iger HF gefüllt (ggf. werden Schichten auf der Halbleiterscheibe vorher abgelöst). Es werden der Rückseitenfotostrom $I_2$ und der Vorderseitenfotostrom $I_1$ orts aufgelöst gemessen. Aus $I_2$ und $I_1$ wird, wie in EPA 0295 440 440 beschrieben, die Diffusionslänge L ermittelt. Daraus wird die Grenzflächenrekombinationsgeschwindigkeit S mit Hilfe der angegebenen mathematischen Formel ortsaufgelöst bestimmt.

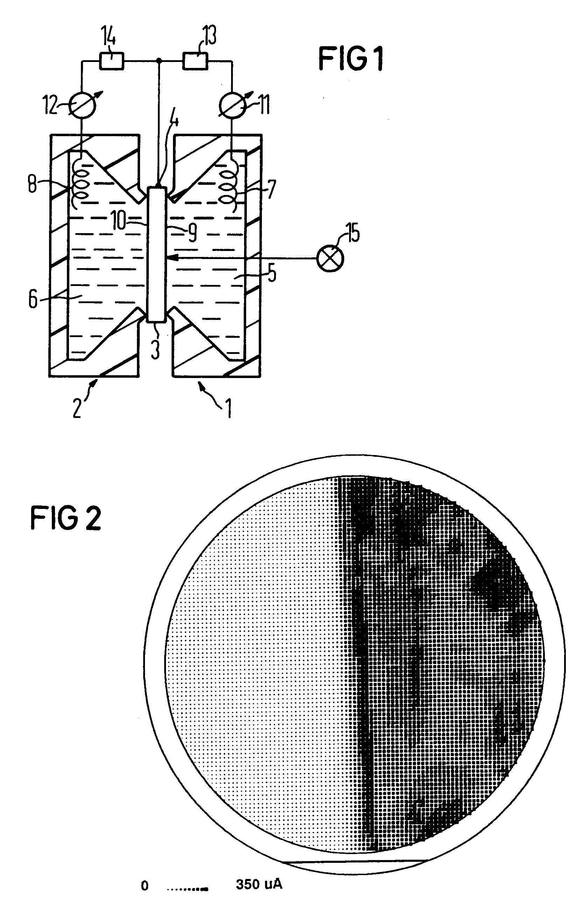

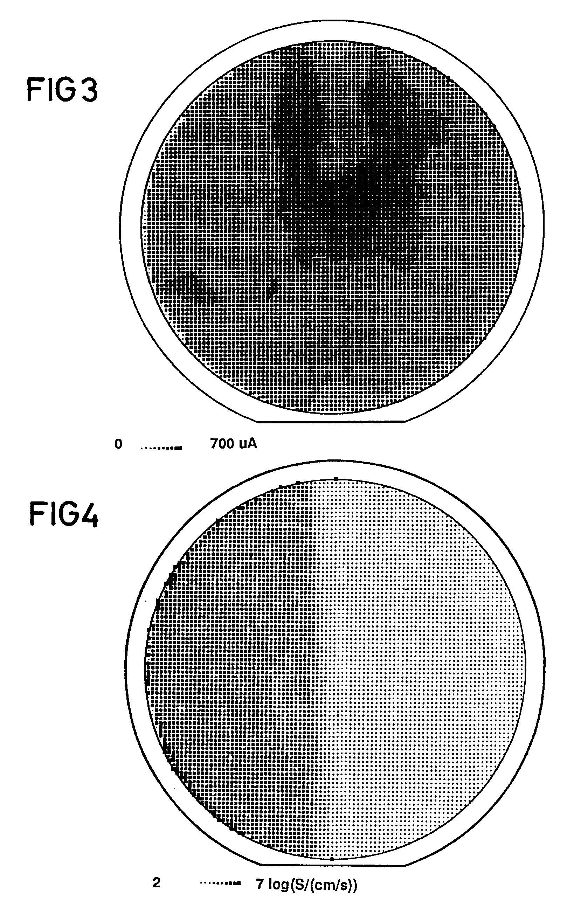

Ein Beispiel für ein Meßergebnis zeigen FIG 2-4. Ein unbehandelter Si-Wafer wurde zur Hälfte für ca. 1 Minute in verdünnte HF-Lösung gehalten (rechte Hälfte in FIG 2). Anschließend wurden wie beschrieben $I_2'$ und $I_2$ gemessen. Die punktweise gemessenen Ströme sind in einer Grautonskala in FIG 2 und 3 dargestellt, wobei die Skalen in den beiden Abbildungen verschieden sind. Aufgrund der Rekombination an Grenzflächenzuständen ist $I_2'$ auf der unbehandelten Seite der Scheibe in FIG 2 sehr klein, während die behandelte und daher praktisch nicht oxidierte Seite höhere Werte zeigt; noch höher liegen die $I_2$-Werte in FIG 3, da nun die Grenzflächenzustände abgesättigt sind. Die quantitative Auswertung mit Hilfe der angegebenen mathematischen Formel ergibt das ortsaufgelöste Meßergebnis der Rekombinationsgeschwindigkeit S, das in FIG 4 dargestellt ist. Die Durchschnittswerte von S liegen bei $3{,}8 \cdot 10^6$ cm/sec. für die unbehandelte Oberfläche und bei $1{,}3 \cdot 10^3$ cm/sec. für die mit HF behandelte Oberfläche.

## Patentansprüche

1. Verfahren zur Bestimmung der Rekombinationsgeschwindigkeit S von Minoritätsträgern an Grenzflächen zwischen einem Halbleiterkristallkörper (3) und anderen Substanzen, bei welchem
   - eine 1. Halbzelle (1) an der Vorderseite (9) des Halbleiterkristallkörpers (3), eine 2. Halbzelle (2) an der Rückseite (10) des Halbleiterkristallkörpers (3) angebracht ist, und beide Halbzellen mit einem Elektrolyt (5,6) befüllbar sind,
   - mindestens die 2. Halbzelle (2) eine Elektrode (8) enthält und mit dem Elektrolyt (6) gefüllt ist, welcher mit der Elektrode (8) und der Rückseite (10) des Halbleiterkristallkörpers (3) in Kontakt steht,
   - mindestens die Elektrode (8) in der 2. Halbzelle (2) über eine Spannungsquelle (14) und einen ohmschen Kontakt (4) an den Halbleiterkristallkörper (3) angeschlossen ist,

- an der Spannungsquelle (14) eine Gleichspannung angelegt wird, so daß an der Rückseite (10) des Halbleiterkristallkörpers (3) eine sperrende Raumladungszone erzeugt wird,
- die Vorderseite (9) mit einer Lichtquelle (15) beleuchtet wird, **dadurch gekennzeichnet, daß**

ein zweistufiges Meßverfahren eingesetzt wird, bei welchem in dem einen Meßschritt nur die 2. Halbzelle (2) elektrolytgefüllt ist und ein in der 2. Halbzelle (2) zwischen Elektrode (8) und Rückseite (10) fließender 1. Fotostrom ($I_2'$) gemessen wird, und in dem anderen Meßschritt beide Halbzellen (1,2) elektrolytgefüllt sind und ein in der 2. Halbzelle (2) zwischen Elektrode (8) und Rückseite (10) fließender 2. Fotostrom ($I_2$) gemessen wird, und daraus mit Hilfe der mathematischen Formel

$$S \; = \; \frac{D \, \alpha \, (1 - A)}{A \, - \, \alpha \, L \, \tanh (X/L)}$$

wobei

| | |
|---|---|
| D | = Diffusionskonstanten der Ladungsträger, |
| $\alpha$ | = Absorptionskonstante des Lichtes, |
| A | = $I_2/I_2'$ = Verhältnis des 2. Fotostroms zum ersten Fotostrom |
| L | = Diffusionslänge, |
| X | = Dicke des Halbleiterkristallkörpers (3), die Grenzflächenrekombinationsgeschwindigkeit S bestimmt wird. |

2. Verfahren nach Anspruch 1, **dadurch gekennzeichnet, daß** die Beleuchtung ganzflächig erfolgt.

3. Verfahren nach Anspruch 1, **dadurch gekennzeichnet, daß** der Lichtstrahl auf die Vorderseite (9) des Halbleiterkristallkörpers (3) fokussiert wird und diese abrastert, so daß eine ortsaufgelöste Messung erfolgt.

4. Verfahren nach einem der Ansprüche 1 bis 3, **dadurch gekennzeichnet, daß** als Lichtquelle (15) ein Laser verwendet wird.

5. Verfahren nach einem der Ansprüche 1 bis 4, **dadurch gekennzeichnet, daß** als Elektrolyt (5, 6) verdünnte Flußsäure mit einer Konzentration C $\cong$ 0,5 % verwendet wird.

6. Verfahren nach einem der Ansprüche 1 - 5 , **dadurch gekennzeichnet, daß**
- die 1. Halbzelle (1) eine Elektrode (7) enthält und mit dem Elektrolyt (5) gefüllt ist, welcher mit der Elektrode (7) und der Vorderseite (9) des Halbleiterkristallkörpers (3) in Kontakt steht,
- die Elektrode (7) in der ersten Halbzelle (1) über eine Spannungsquelle (13) und den ohmschen Kontakt (4) an den Halbleiterkristallkörper (3) angeschlossen ist,
- an der Spannungsquelle (13) eine Gleichspannung angelegt wird, so daß an der Vorderseite (9) eine sperrende Raumladungszone erzeugt wird,
- in dem anderen Meßschritt ein in der 1. Halbzelle (1) zwischen Elektrode (7) und Vorderseite (9) fließender 3. Fotostrom ($I_1$) zusätzlich gemessen wird und
- aus dem 2. und 3. Fotostrom die Diffusionslänge (L) berechnet wird.

## Claims

1. Method for determining the recombination rate S of minority carriers at boundary surfaces between a semiconductor crystal body (3) and other substances, in which method
- a 1st half cell (1) is attached to the front side (9) of the semiconductor crystal body (3), a 2nd half cell (2) is attached to the rear side (10) of the semiconductor crystal body (3), and both half cells can be filled with an electrolyte (5, 6),
- at least the 2nd half cell (2) contains an electrode (8) and is filled with the electrolyte (6), which is in contact with the electrode (8) and the rear side (10) of the semiconductor crystal body (3),
- at least the electrode (8) in the 2nd half cell (2) is connected to the semiconductor crystal body (3) via a voltage source (14) and an ohmic contact (4),
- a DC voltage is applied to the voltage source (14), so that an inhibiting space charge zone is generated at the rear side (10) of the semiconductor crystal body (3),
- the front side (9) is illuminated with a light source (15), characterized in that

a two-stage measuring method is utilized, in which only the 2nd half cell (2) is filled with electrolyte in the one measuring step and a first photocurrent ($I_2'$) flowing in the 2nd half cell (2) between electrode (8) and rear side (10) is measured, and both half cells (1, 2) are filled with electrolyte in the other measuring step and a 2nd photocurrent ($I_2$) flowing in the 2nd half cell (2) between electrode (8) and rear side (10) is measured, and the boundary surface recombination rate S is determined therefrom with the aid of the mathematical formula

$$S = \frac{D\,\alpha\,(1-A)}{A - \alpha\,L\,\tanh(X/L)}$$

where

D = diffusion constants of the charge carriers
$\alpha$ = absorption constant of the light,
$A = I_2/I_2'$ = ratio of the 2nd photocurrent to the first photocurrent
L = diffusion length,
X = thickness of the semiconductor crystal body (3).

2. Method according to Claim 1, characterized in that the illumination takes place over the entire surface.

3. Method according to Claim 1, characterized in that the light beam is focussed onto the front side (9) of the semiconductor crystal body (3) and scans said front side, so that a topically resolved measurement takes place.

4. Method according to one of Claims 1 to 3, characterized in that a laser is used as light source (15).

5. Method according to one of Claims 1 to 4, characterized in that dilute hydrofluoric acid of a concentration $C \cong 0.5\%$ is used as electrolyte (5, 6).

6. Method according to one of Claims 1 - 5, characterized in that
   - the 1st half cell (1) contains an electrode (7) and is filled with the electrolyte (5), which is in contact with the electrode (7) and the front side (9) of the semiconductor crystal body (3),
   - the electrode (7) in the first half cell (1) is connected to the semiconductor crystal body (3) via a voltage source (13) and the ohmic contact (4),
   - a DC voltage is applied to the voltage source (13), so that an inhibiting space charge zone is generated at the front side (9),
   - a 3rd photocurrent ($I_1$) flowing in the 1st half cell (1) between electrode (7) and front side (9) is additionally measured in the other measuring step and
   - the diffusion length (L) is calculated from the 2nd and 3rd photocurrent.

**Revendications**

1. Procédé pour déterminer la vitesse de recombinaison S de porteurs minoritaires au niveau d'interfaces entre un corps cristallin semiconducteur (3) et d'autres substances, selon lequel
   - une 1-ère demi-cellule (1) est disposée sur la face avant (9) du corps cristallin semiconducteur (3) et une 2-ème demi-cellule (2) est disposée sur la face arrière (10) du corps cristallin semiconducteur (3), et les deux demi-cellules peuvent être remplies par un électrolyte (5, 6),
   - au moins la 2-ème demi-cellule (2) comporte une électrode (8) et est remplie par l'électrolyte (6), qui est en contact avec l'électrode (8) et avec la face arrière (10) du corps cristallin semiconducteur (3),
   - au moins l'électrode (8) située dans la 2-ème demi-cellule (2) est raccordée, par l'intermédiaire d'une source de tension (14) et d'un contact ohmique (4), au corps cristallin semiconducteur (3),
   - une tension continue est appliquée à la source de tension (14) de sorte qu'au niveau de la face arrière (10) du corps cristallin semiconducteur (3) est produite une zone de charges d'espace réalisant un blocage,
   - la face avant (9) est éclairée par une source de lumière (15),
   caractérisé par le fait qu'on utilise un procédé de mesure en deux étapes, selon lequel, lors d'une étape de mesure, on remplit avec l'électrolyte uniqeument la 2-ème demi-cellule (2) et on mesure un 1-er courant photoélectrique ($I_2'$) qui circule dans la 2-ème demi-cellule (2) entre l'électrode (8) et la face arrière (10) et, dans l'autre étape de mesure, on remplit avec un électrolyte les deux demi-cellules (1, 2) et on mesure un 2-ème courant photoélectrique ($I_2$) qui circule dans la 2-ème demi-cellule (2) entre l'électrode (8) et la face arrière (10), et à partir de là on détermine la vitesse S de recombinaison au niveau des interfaces à l'aide de la formule mathématique

$$S = \frac{D\,\alpha\,(1-A)}{1 - \alpha\,L\,\tanh\,(X/L}$$

avec

D = constante de diffusion des porteurs de charge,

$\alpha$ = constante d'absorption de la lumière,

a = $I_2/I_2'$ = rapport du 2-ème courant photoélectrique au 1-er courant photoélectrique,

L = longueur de diffusion

X = épaisseur du corps cristallin semiconducteur (3).

2. Procédé suivant la revendication 1, caractérisé par le fait que l'éclairement s'effectue sur toute la surface.

3. Procédé suivant la revendication 1, caractérisé par le fait qu'on focalise le faisceau de lumière sur la face avant (2) du corps cristallin semiconducteur (3) et qu'on réalise une exploration par balayage de trame de ce corps de sorte qu'on obtient une mesure à résolution locale.

4. Procédé suivant l'une des revendications 1 à 3, caractérisé par le fait qu'on utilise un laser comme source de lumière (15).

5. Procédé suivant l'une des revendications 1 à 4, caractérisé par le fait qu'on utilise comme électrolyte (5, 6) de l'acide fluorhydrique dilué en une concentration C $\cong$ 0,5 %.

6. Procédé suivant l'une des revendications 1-5, caractérisé par le fait que
   - la 1-ère demi-cellule (1) comporte une électrode (7) et est remplie par l'électrolyte (5), qui est en contact avec l'électrode (7) et la face avant (9) du corps cristallin semiconducteur (3),
   - l'électrode (7) située dans la première demi-cellule (1) est raccordée, par l'intermédiaire d'une source de tension (13) et du contact ohmique (4), au corps cristallin semiconducteur (3),
   - une tension continue est appliquée à la source de tension (13) de sorte qu'une zone de charges d'espace exécutant un blocage est produite au niveau de la face avant (9),
   - lors de l'autre étape de mesure, on mesure en supplément un 3-ème courant photoélectrique ($I_1$) qui circule dans la 1-ère demi-cellule (1), entre l'électrode (7) et la face avant (9), et
   - on calcule la longueur de diffusion (L) à partir des 2-ème et 3-ème courants photoélectriques.

FIG 1

FIG 2

0 .........■ 350 uA

FIG 3

0 ........... 700 uA

FIG4

2 .........■ 7 log(S/(cm/s))